# EUROPEAN PATENT APPLICATION

(11) **EP 4 443 172 A1**
(43) Date of publication of application: **09.10.2024**
(21) Application number: 23167153.8
(22) Date of filing: 06.04.2023
(51) Int. Cl.: G01R 1/073, G01R 31/28, G01R 1/067, G01R 27/20, G01R 31/26

(54) **METHOD OF AND SENSING PROBE DEVICE FOR MEASURING A PARAMETER OF A QUANTUM CHIP**

(71) Applicant: Nederlandse Organisatie voor toegepast-natuurwetenschappelijk Onderzoek TNO, 2595 DA 's-Gravenhage (NL)
(72) Inventor: MICHALAK, David Jason, 2595 DA 's-Gravenhage (NL); WILLIGERS, Timo Jean Jozef, 2595 DA 's-Gravenhage (NL)
(74) Representative: V.O.

(57) **Abstract**

The present invention is directed at a method of measuring a parameter of a quantum chip using at least one sensing probe device, the quantum chip comprising a quantum device and at least one probe pad in conductive contact with the quantum device for enabling said measuring, wherein the method comprises the steps of: engaging contact between the at least one sensing probe device and a contact surface of the probe pad; an measuring, using the sensing probe device in contact with the probe pad, the parameter of the quantum device. The invention is further directed at a sensing probe device, a probe station and a computer program product.

## Description

### Field of the invention

The present invention is directed at a method of measuring a parameter of a quantum chip using at least one sensing probe device, the quantum chip comprising a quantum device and at least one probe pad in conductive contact with the quantum device for enabling said measuring, wherein the method comprises the steps of: engaging contact between the at least one sensing probe device and a contact surface of the probe pad; an measuring, using the sensing probe device in contact with the probe pad, the parameter of the quantum device. The invention is further directed at a sensing probe device, a probe station and a computer program product.

### Background

Chips designed for quantum computing applications contain probe pads composed of non-standard materials and/or non-standard fabrication methods. This leads to contaminations of various nature. As a result, quantum chips are much more challenging to measure using the normal automated methods currently available on probe stations. Reliability of measurement results is thereby compromised, which complicated automation of this process. This challenge is magnified during low-temperature (cryogenic) measurement conditions.

Existing solutions are directed at applying sufficient force between the probe needle and the pad such that the needle scratches a few tens to hundreds of micrometers along the probe pad surface, thereby cleaning off residue as it scratches a path. This is referred to as 'over travel'. Although this improves the measurements results, this is not achieved consistently and thus still leaves the measuring process to be insufficiently reliable.

### Summary of the invention

It is an object of the present invention to overcome the difficulties and disadvantages of conventional methods and systems, and provide for a reliable method of measuring a parameter of a quantum chip that may be carried out manually and that is also suitable for being automated.

To this end, in accordance with a first aspect of the invention, there is provided herewith a method of measuring a parameter of a quantum chip using at least one sensing probe device, the quantum chip comprising a quantum device and at least one probe pad in conductive contact with the quantum device for enabling said measuring, wherein the method comprises the steps of: a. engaging contact between the at least one sensing probe device and a contact surface of the probe pad; and c. measuring, using the sensing probe device in contact with the probe pad, the parameter of the quantum device; wherein the sensing probe device comprises at least two probe tips, the at least two probe tips being electrically separated from each other, and wherein prior to step c. and after step a., the method comprises a step b. of conductance testing and conditional surface conditioning of the contact surface, the step b. comprising at least the sub-steps of: b1. measuring a contact impedance between the at least two electrically separated probe tips, the at least two electrically separated probe tips being in contact with the contact surface; b2. determining, based on the measured contact impedance, whether the contact impedance sufficient for enabling the measuring of the parameter of the quantum device in step c.; b3. if in step b2. it is determined that the contact impedance is insufficient, perform a step of surface conditioning on the contact surface of the probe pad for lowering the contact impedance.

The present invention, upon establishing contact between the sensing probe device and the contact surface of the probe pad, measures the contact impedance of the contact between the sensing probe device and the contact surface. In most cases (but not exclusively), measuring the contact impedance comes down to measuring the contact resistance of the contact, and thereby providing a measurement of the electric contact conductance. If the electric conductance of the contact between the sensing probe device and the contact surface is sub-optimal, i.e. the contact resistance is too high, the measurement signal obtained during step c. of measuring the parameter of the quantum device may be too weak to provide a reliable measurement result. Therefore, by additionally measuring the contact impedance upon engagement of contact between the sensing probe device and the probe pad, an insufficient (i.e. too large) impedance will be detected prior to measurement and adequate action may be taken to resolve this. In particular, the conditional step of surface conditioning (e.g. by further overtravel, scratching, or electric stress by a voltage or current) for removing contaminants or an oxide layer may be applied in order to improve electrical conductance.

To measure the contact impedance, in accordance with the present invention, the sensing probe device comprises at least two probe tips that are electrically separated or isolated from each other. Contact between the sensing probe device and the probe pad is then established by establishing contact between the at least two probe pads and the contact surface of the probe pad. By doing so, contact impedance can be measured using the at least two probe tips. For example, the at least two electrically separated probe tips may form a circuit via the contact surface. The contact impedance may then be determined e.g. by measuring the voltage drop over the contact surface at a known applied current, or by measuring the current through the contact surface at a known applied voltage over the probe tips, or by measuring an current-voltage characteristic (e.g. by applying multiple voltages or currents), or by measuring capacitance or maybe even inductance between the probe tips.

In step b2, the contact impedance measured in step b1. may be compared against a threshold or reference value to determine whether the contact impedance sufficient for enabling the measuring of the parameter of the quantum device in step c. In some embodiments, as mentioned the contact impedance may be identified as being lower than the threshold for providing a sufficient electrical conductance for obtaining a strong enough electric measurement signal in order to measure the parameter correctly. In other embodiments, the method may also be used to compare the measured contact impedance with earlier or alternatively measured contact resistances of different measurements. In this case, it becomes possible to continue step b3. of surface conditioning until the measured contact impedance is similar (i.e. of a same magnitude or within a same predefined range or e.g. less than a certain percentage deviating) to one or more alternative or earlier determined contact resistance measurements. This enables to ensure that the intensities of the electric measurement signals become comparable to each other, because the contact impedances are similar.

In some embodiments, after the step of surface conditioning in step b3. the method further comprises repeating steps b1., b2., and b3. until in step b2. it is determined that the contact impedance is sufficient for enabling the measuring of the parameter of the quantum device in step c. In accordance herewith, the steps b1., b2., and b3. are repeated until proper electric conductance (i.e. a sufficiently low contact impedance) has been achieved. In particular, by repeating these steps until contact resonance is sufficiently low, it is ensured that with every measurement taken in step c. reliable measurement results of the parameter of the quantum device are obtained. Therefore, repeating these steps for every measurement renders the method suitable for automating the process of quantum chip read-out.

In other or further embodiments, step b. further comprises a sub-step of: b4. if in step b2. it is determined that the contact impedance is insufficient, continuing the method with step c. of measuring the parameter of the quantum device. This more or less also follows from the above: if step b3 is no longer required in view of the determination in step b2, then the method proceeds with the measuring in step c.

In some embodiments, the sensing probe device comprises at least two probes, wherein each probe of the at least two probes comprises a probe tip, such as to provide the at least two electrically separated probe tips; and wherein in step a. contact is engaged between the contact surface of the probe pad and each probe tip of the at least two probe tips; and wherein in step c. the measuring is performed using at least one of the at least two probe tips in contact with the probe pad. Here, the sensing probe device may comprise two electrically separated probes bearing probe tips.

In yet alternative embodiments, the sensing probe device comprises a probe, wherein the probe includes the at least two electrically separated probe tips; wherein in step a contact is engaged simultaneously between the contact surface of the probe pad and each of the at least two probe tips; and wherein in step c. the measuring is performed using at least one of the at least two probe tips in contact with the probe pad. In these preferred embodiments, the sensing probe device includes a probe having two electrically separated probe tips integrated thereon. The probe tips may for example be electrically isolated, or even shielded, from each other; although the probe provides a single carrier structure enabling the probe tips to be located very close to each other.

In some embodiments, in step b3. the step of surface conditioning comprises at least one of several of the following steps, although this list is not exclusive in any way. The step of surface conditioning may comprise moving the probe tips relative to the probe pad while the probe tips are in contact with the contact surface, for performing a mechanical scratching operation. Scratching includes the abovementioned process of over travel of the probe tip on the contact surface of the probe pad, but may likewise include a back and forth going scratching operation. The step of surface conditioning may further or alternatively comprise disengaging and re-engaging contact between the at least two probe tips and the contact surface, i.e. in order to obtain a more conductive contact. Furthermore, the step of surface conditioning may comprise applying a voltage between the at least two probe tips for electrically breaking down an insulating contamination between at least one of the probe tips and the probe pad. Alternatively or additionally, the step of surface conditioning may comprise applying a current via the at least two probe tips for electrically breaking down an insulating contamination between at least one of the probe tips and the probe pad. Good results may be achieved with scratching (including further over travel), but in those events where this is not sufficient for increasing electrical conductance (hence: decreasing contact resonance), other conditioning methods may be applied. One of these includes the application of electrical stress to remove or break contaminants. The electrical stress approach may not per sé be desired, but sometimes may be the only way to get sufficiently good contact after significant scratching is not successful. It for example includes the application of voltage or current between the two probes to electrically breakdown the insulating material between the probe and pad.

In some embodiments, as mentioned here before, in step b 1. the measuring of a contact impedance comprises at least one of: contact resistance measurements, capacitive measurements, inductance measurements, current measurements, voltage measurements. The main objective is to gain insight in the contact impedance, in particular contact resistance. This may likewise include capacitance measurements to gain insight in the potential build-up of stray capacitance that may be detrimental to measurements performed in step c.

In other or further embodiments, the quantum device comprises at least two probe pads and wherein the measuring is performed using at least two sensing probe devices. Herein, step a. at least comprises the sub-steps of: a1. engaging contact between a first sensing probe device of the at least two sensing probe devices and a contact surface of a first probe pad of the at least two probe pads; and a2. engaging contact between a second sensing probe device of the at least two sensing probe devices and a contact surface of a second probe pad of the at least two probe pads. Furthermore, herein step b. is performed for each one of the first and second sensing probe device in contact with respectively the first and second probe pad. Hereinabove and before, the method has been described with reference to measuring a single probe pad, but in many events may be carried out by measuring the parameter of the quantum device via two (or sometimes more than two) probe pads. The method may be applied in a same manner, *mutatis mutandis.*

In yet further embodiments, the quantum chip comprises a plurality of quantum devices, each quantum device being in conductive contact with one or more probe pads, wherein the method is performed for two or more quantum devices of the plurality of quantum devices. In other or further embodiments, the quantum chip is provided on a substrate, wherein the substrate comprises a plurality of quantum chips, and wherein the method is performed for each quantum chip on the substrate. The method of the present invention may be automatically applied using a probing station including a controller in communicative connection with a memory or external data repository. The memory or data repository may contain a computer program product, containing instructions for enabling the controller to control the operation of the probing station, in order to enable the probing station to perform a method in accordance with any of the above embodiments or examples in accordance with the appended claims. For example, in accordance with an exemplary embodiment, the method may automatically applied in the above manner for measuring the parameter of a plurality of quantum devices in a chip, or a plurality of quantum chips on a substrate.

In accordance with a second aspect thereof, there is provided a sensing probe device for use in a method according to the first aspect, for measuring a parameter of a quantum chip, the quantum chip comprising a quantum device and at least one probe pad in conductive contact with the quantum device, wherein the sensing probe device is mountable to an actuator for enabling the sensing probe device to engage contact with a contact surface of the at least one probe pad, wherein the sensing probe device is configured for enabling measuring, using the sensing probe device in contact with the probe pad, the parameter of the quantum device; wherein the sensing probe device, for contacting the contact surface, comprises at least two probe tips which are electrically separated from each other, wherein each of the at least two probe tips is electrically connected separately such to convey an electrical signal thereto, for enabling measuring a contact impedance between the at least two electrically separated probe tips when said probe tips are in contact with the contact surface. The described probe tip may suitably be applied in a method of the first aspect, in order to enable the measuring of a contact impedance or contact resonance.

In some embodiments, each of the at least two probe tips is electrically connected to a signal connector via a signal lead, and wherein each of the signal leads is electrically shielded from its environment. The electrical signals are to be conveyed separately to a connector or input/output port in order to reliably perform the contact impedance measurements. In particular, when this includes measuring a contact capacitance, the shielding of the signal leads is important to prevent stray capacitance between the signal lines. However, also in other circumstances, such as the conveying of very weak signals, the use of shielding aids in reliable transport of these signals to the connector or output port. In some of these embodiments, the electric shielding is provided by a driven shield, the driven shield being connected such as to be maintained, in use, at a same voltage as the respective signal lead. Using driven shields is in itself an effective method of shielding under the described circumstances, and thus provides advantages in these embodiments.

In other or further embodiments, the sensing probe device is a cryogenic probe device including cooling means for maintaining the probe and probe tips in use at a cryogenic temperature. Cryogenic probes are often used for sensing the parameters of quantum chips or quantum devices.

In some embodiments, sensing probe devices may comprise at least a first needle and a second needle, wherein the first needle and the second needle are supported on a carrier structure, such as a support arm, and wherein a first probe tip of the at least two probe tips is formed on the first needle and a second probe tip of the at least two probe tips is formed on the second needle, wherein the first needle and the second needle are electrically separated from each other for forming a first signal lead and a second signal lead respectively. The needles may effectively be used as signal leads for the probe tips formed at the end of each needle, whereas the carrier structure allows to integrate these elements on a single probe with two (or more) probe tips.

In accordance with a third aspect, there is provided a probe station for measuring a parameter of a quantum chip, the quantum chip comprising a quantum device and at least one probe pad in conductive contact with the quantum device for enabling said measuring, wherein the probe station comprises one or more sensing probe devices according to the second aspect, wherein the probe station comprises or is configured for operatively connecting to a data acquisition system for processing measurements obtained by said measuring, and wherein the probe station comprises a controller, a memory and one or more actuators operated by the controller and configured for operating the one or more sensing probe devices for performing a method according to the first aspect.

In accordance with a fourth aspect, there is provided a computer program product comprising instructions which, when the program is executed by a probe station comprising a controller and memory, cause the probe station to carry out the steps of the method according to the first aspect.

### Brief description of the drawings

The invention will further be elucidated by description of some specific embodiments thereof, making reference to the attached drawings. The detailed description provides examples of possible implementations of the invention, but is not to be regarded as describing the only embodiments falling under the scope. The scope of the invention is defined in the claims, and the description is to be regarded as illustrative without being restrictive on the invention. In the drawings:
Figure 1a and 1b schematically illustrate a substrate comprising quantum devices forming a quantum chip;
Figures 2a and 2b schematically illustrate surface contaminations experienced during measuring of a quantum device;
Figures 3a and 3b schematically illustrate contact impedance measurements in accordance with an embodiment of the present invention;
Figure 4 schematically illustrates a conditional step of surface conditioning in accordance with an embodiment of the present invention;
Figures 5a and 5b illustrate an additional or alternative step of surface conditioning in accordance with an embodiment of the present invention;
Figure 6 schematically illustrates the method in accordance with an embodiment of the present invention;
Figure 7 schematically illustrates a sensing probe device in accordance with an embodiment of the present invention;
Figure 8 schematically illustrates a sensing probe device in accordance with an embodiment of the present invention;
Figures 9a and 9b schematically illustrate a sensing probe device in accordance with an embodiment of the present invention;
Figures 10a and 10b schematically illustrate a sensing probe device in accordance with an embodiment of the present invention.

### Detailed description of the figures

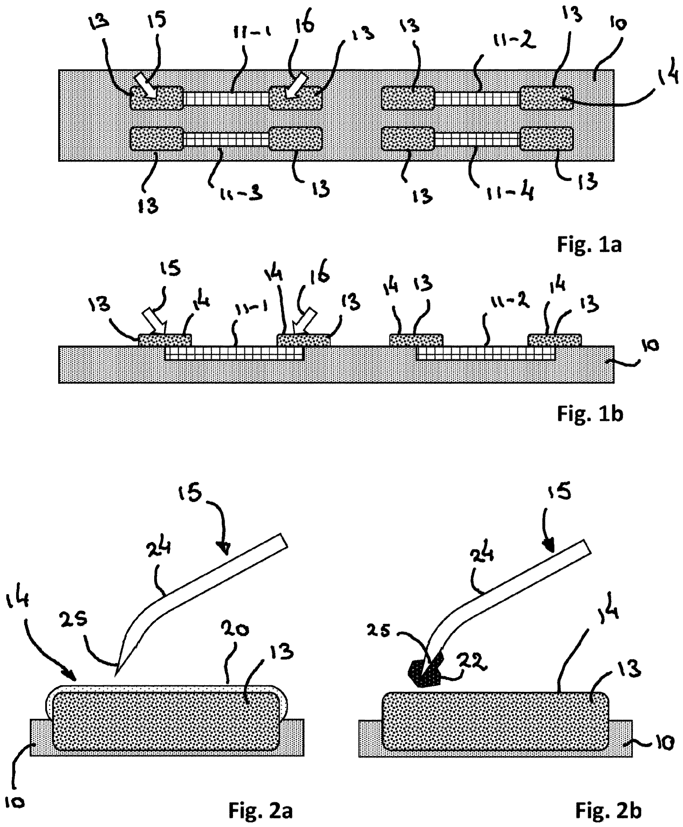

Figures 1a and 1b schematically illustrate a silicon wafer substrate 10 comprising a plurality of quantum devices 11-1, 11-2, 11-3 and 11-4 which together are part of a greater quantum chip structure (not numbered). Figure 1b illustrates the schematic wafer 10 in side-view, whereas figure 1a illustrates the schematic wafer 10 from top-down. Each of the devices 11-1 to 11-4 is connected to a first and a second probe pad 13. The probe pads 13 allow to measure the parameter of the devices 11-1 to 11-4. To do so, as is illustrated for device 11-1, a first sensing probe device 15 and the second sensing probe device 16 is brought in contact with either one of the respective probe pads 13. As may be appreciated, although in figures 1a and 1b each of the devices 11-1 through 11-4 include two probe pads, some quantum devices may be measured using only a single probe pad, for example relative to an electric ground electrode. A measuring of the parameters of such types of quantum devices, via a single probe pad 13, may be performed using a method in accordance with an embodiment of the present invention as well.

The signals obtained via the sensing probe devices 15 and 16 enable to determine the parameter of the quantum device 11-1. However, in many of such measurements the contact impedance potentially can disturb the measurement significantly. For example, if the parameter to be measured is the internal electrical resistance of the device and this resistance is expected to be around 100 ohm (100Ω), the contact resistance must be significantly lower (e.g. < 50 Ω or maybe even < 10 Ω) Therefore, in order to be able to reliably measure the parameter of the quantum device 11-1, a sufficiently good conductive contact with the probe tip 13 needs to be established for each of the first and second sensing probe device 15 and 16. If the contact impedance becomes too large, the measurements may be disturbed and cannot be properly be performed. In many occasions, superconducting materials are applied as materials for the probe pads 13 in order to enable these measurements.

Figures 2a and 2b schematically illustrate the probing of a probe pad 13 with a conventional probe 24 with probe tip 25. To establish contact, the probe 15 typically engages contact with the probe pad 13 on the contact surface 14 thereof. However, various factors negatively influence the conductance of the established contact between the probe 24 and the probe pad 13. For example, as illustrated in figure 2a, the contact surface 14 may be covered with an insulating oxide layer 20. The layer 20 locally increases the electrical resistance of the surface 14. When the probe tip 25 engages the probe pad 13, preferably the probe tip 25 may at least partially penetrate the insulating oxide layer 20 in order to establish a good conductive contact with the material of the probe pad 13 underneath the layer 20. However, whether this succeeds differs with each engagement step, and is for example also dependent on the sharpness of the probe tip 25, the actuating force, and the softness/hardness of the probe pad material and the oxide layer. In may cases, the probe tip 25 will not (completely) be able to penetrate the insulating oxide layer 20, and therefore the contact resistance after engagement of the probe 24 on the probe pad 13 is higher than desired. Another typical problem is illustrated in figure 2b. Here, the probe 24 has a probe tip 25, which is covered with contamination 22 which is attracted or contracted from the contact surface 14. For example, the probe 24 may have picked up such contaminations 22 from an earlier contact engagement with a different probe pad 13. If the contaminations 22 cover the probe tip 25, contact engagement of the probe 24 with the surface 14 of probe pad 13 may not lead to a satisfactory contact resistance. For example the contamination 22 may have increased the electrical resistance between the contact surface 14 and the material of the probe tip 25 (in an electronic replacement scheme adding an additional resistor of unknown magnitude thereto). To resolve this, upon engaging contact between the probe 24 and the probe pad 13, the probe tip 25 may be moved across the contact surface 14 over an additional excess length. This is called 'overtravel' of the probe tip 25 on the surface 14, and may improve the conductance of the contact experienced. However, it may likewise result in adding contaminations 22 to the probe tip 25 for example because debris from layer 20 may build up on the probe tip 25 and form the contaminations 22. Contaminations of different nature may also be picked up in this manner. Therefore, the applied method is no guarantee for success.

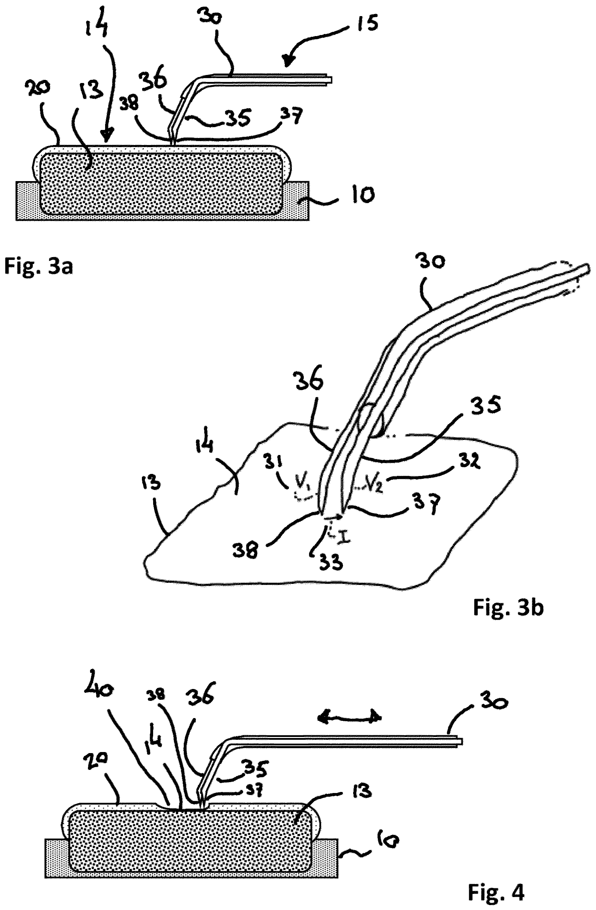

Figures 3a and 3b schematically illustrate the measuring of a contact impedance of a contact surface 14 of a probe pad 13 in accordance with a step in an embodiment of the method of the present invention. The contact impedance measurements may for example be performed with a probe 15 comprising a support arm 13 onto which a first and a second probing needle 35 and 36 are mounted. Each needle 35 and 36 respectively comprises a probe tip 37 and 38. The needles 35 and 36 are electrically separated from each other.

To measure the contact impedance, contact is engaged between the probe 15 and the probe pad 13. Thereafter, the contact impedance may be measured using various different methods. For example, as is illustrated in figure 3b, each of the needles 35 and 36 may be held at a different voltage 31, 32 such as to yield a voltage difference V₂ - V₁. The current 33 (I in figure 3b) between the probe tips 37 and 38 may then be determined in order to calculate the contact resistance. Other methods of measuring the contact impedance include the measuring of a contact capacitance between the probe tips 37 and 38.

Thereafter, as is illustrated in figure 4, if the contact impedance is found to be too large, for example by comparing it against a threshold, a step of surface conditioning needs to be performed. Figure 4 illustrates such a step of surface conditioning. The step of surface conditioning is itself a conditional step in the sense that it may be applied dependent on whether or not the contact impedance is found to be too large. In this manner, the step is only carried out when needed, and the result of this can be checked by performing another contact impedance measurement after it has been carried out. If no surface conditioning step is needed, it (step b3 of claim 1) may also simple be omitted in order to gain efficiency and to prevent unnecessary wear to the probe tip.

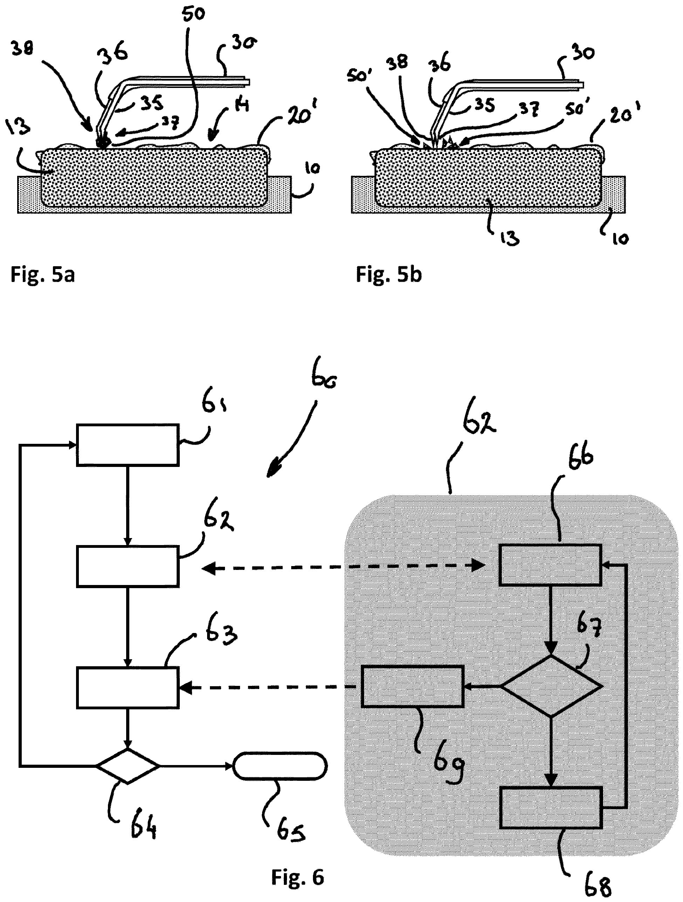

If a contact impedance is too large, the step of surface conditioning is performed to lower the contact impedance and thereby improve the conductance of the contact, however if on the other hand the contact impedance is already lower than a predefined or preselected threshold, no further surface conditioning may be needed. This threshold is typically determined by the experiment to be done, and thus there is no standard value that can be given here. As stated above, when measuring a resistance value of 10 Ω, the contact resistance is preferably lower than 1 Ω; when measuring a resistance value of 1 Ω, the contact resistance is preferably lower than 0.1 Ω (i.e. <100 m SZ). The contact impedance may, alternatively and in accordance with an embodiment, also be compared against contact impedances of other probe pads 13, for example in order to ensure that they are all within the same narrow range. In figure 4, the surface conditioning step is performed by a mechanical scratching step by moving the probe 15 back and forth a few times, while in contact with the contact surface 14 of the probe pad 13. The mechanical scratching may alternatively also merely include a step of overtravel, as described before, but then dependent on the measured contact impedance. If the mechanical scratching step is not sufficient, other steps may likewise be applied. For example, figures 5a and 5b illustrate an alternative surface conditioning step in order to enable removing contaminants between the probe tips 37 and 38 and the contact surface 14. In figures 5a and 5b, as is illustrated in figure 5a, the contamination 50 is present between the probe tips 37 and 38. The contamination 50 may for example have been picked up by the probe tips 37 and 38 during earlier surface contact, and may reside in an undesired location wherein it increases the contact resistance (here exactly between the probe tips 37 and 38). A mechanical scratching step may not be sufficient in figure 5a in order to remove the contamination 50. Alternatively, the contamination 50 may also be removed in a different manner, by applying a voltage or current across the probe tips 37 and 38 and through the contamination 50. Due to electrical stress induced by the current or voltage difference, the contamination 50 may break up into debris 50'. This is illustrated in figure 5b. Here, the debris 50' may still be present on the surface 14 of the probe pad 13, however it is not present underneath the probe tips 37 and 38, and therefore a sufficiently contact conductance is achieved.

What figures 5a and 5b also show is that insulating layer 20' which may be an oxide layer, may not have the same thickness everywhere on the surface 14 of the probe pad 13. For example, more oxide may be present at some locations and in other locations on the surface 14 of the probe pad 13. As a result, if, during measurement of the contact impedance, it is determined that the contact resistance may be too high in order to obtain a proper measurement of the parameter of the quantum device 11, a step of this engaging the sensing probe device 15 from the probe pad 13 and re-engaging the sensing probe device 15 on the probe pad 13 may be sufficient to establish a prober electric contact therebetween. In the present case, upon re-engaging the contact surface 14, the chances are realistic that contact will be established in a slightly different location, where possibly less or even no oxide layer 20' may be present. This thereby thus improves the conductance of the contact considerably.

Figure 6 schematically illustrates a method in accordance with the present invention. On the left side of the figure, the method 60 is generally illustrated. The method 60 starts with a step of engaging contact between the at least one probing device 15, 16 and a contact surface 14 of a probe pad 13. Once this has been performed, in step 62, the method comprises a step of conductance testing and conditional surface conditioning of the contact surface 14. This is performed using a sensing probe device 15 or 16 which comprises at least two probe tips 37, 38 which are electrically separated from each other, as illustrated herein above (e.g. figures 3a and 3b). Once good contact has been established, the method continues in step 63 where, by means of the sensing probe devices 15, 16 in contact with the probe pad 13, the parameter of the quantum device 11 is measured. Thereafter, it is determined whether a further measurement is to be performed, for example on a different quantum device or on a different quantum chip. If indeed a further measurement needs to be performed, the method 60 continues again in step 61. Otherwise, in step 65, the method is terminated.

The above method may easily be automated in order to perform measurements on quantum chips and quantum chip devices 11 in a plurality of locations. The method of the present invention thereby allows to measure the quantum state of many quantum devices, which is a major step forward in the process of the quantum chip read-out and testing, and enables industrialization thereof.

Also in figure 6, on the right side, the sub-steps of step 62 are schematically illustrated. Step 62 is carried out by a sub-step 66 of measuring contact impedance between the at least two separated probe tips 37 and 38 of the sensing probe device 15, which are in contact with the contact surface 14 of the probe pad 13. The measuring of contact impedance may be amended in various different ways as discussed above. In step 67, it is determined based on the measured contact impedance, whether the contact impedance is sufficient for enabling the measuring of the eternal state of the quantum device 11 in a subsequent step. For example, if the contact impedance is too large, for example larger than a pre-defined threshold, the method will continue in sub-step 68. However, if the contact impedance is determined to be sufficiently low, and in principal the method 60 of the present invention may continue directly in step 63 described above, wherein the parameter of the quantum device 11 is determined. Optionally, as is the case in figure 6, the method may comprise a sub-step 69 wherein the controller of the probing station determines through which one of the two needles 35 and 36 or via both needles 35 and 36, the measurement 63 will be performed. Step 69 may be omitted from the method 60.

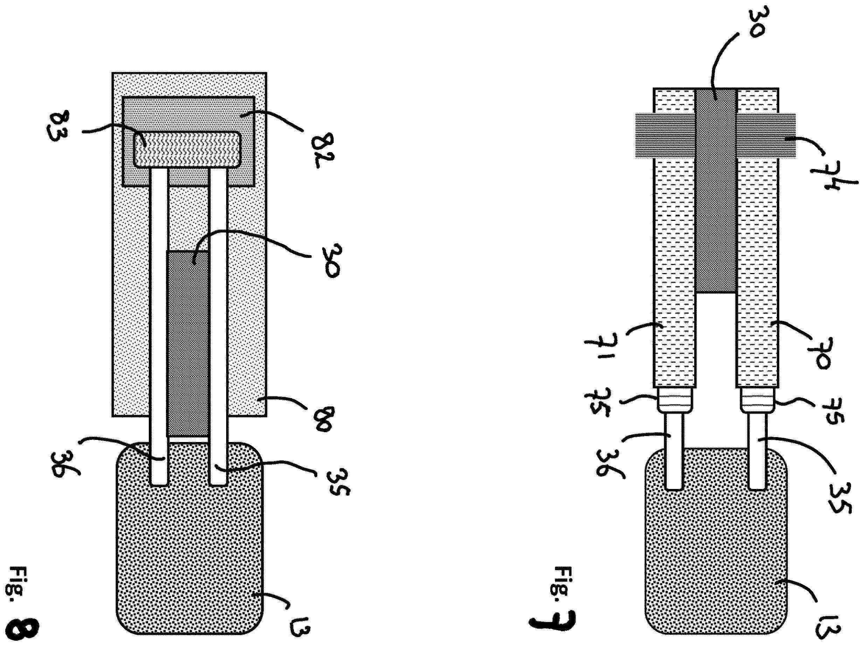

Figures 7, 8, 9a, 9b, 10a and 10b illustrate various embodiments of sensing probe devices that may be used in a method in accordance with the present invention. In figure 7, a sensing probe device is illustrated including a support arm 30 that supports a first needle 35 and a second needle 36. The needles 35 and 36 are mounted via a connector 75 respectively to a first driven shielding 70 and a second driven shielding 71. The driven shieldings 70 and 71 are held at a same voltage as the voltage of needles 35 and 36, and thereby prevent stray capacitance from being present between the needles 35 and 36. As a result the contact impedance measurements are not influenced by such a stray capacitance, and may be reliably performed. The needles 35 and 36 with shieldings 70 and 71 are mounted on the support arm 30 via straps 74. As may be appreciated, this may be replaced by different mounting means, such as a glue, dependent on the circumstances. Because the sensing probe devices 15 and 16 in accordance with the present invention are often used at cryogenic temperatures (i.e. 120 K (-153 degrees Celsius) and below), the use of a glue in many cases may be more preferred than straps 74.

Figure 8 illustrates a different embodiment of a sensing probe device in accordance with the present invention. In figure 8, a support arm 30 again supports a first needle 35 and a second needle 36 that may be brought in contact with probe pad 13. The needles 35 and 36 are at their back and connected to wiring 83 and a connector 82. As described above, the needles 35 and 36 are electrically separated from each other, and are able to convey the electrical signals from the probe tips 37 and 38 respectively towards the wiring 83 on the connector 82. The needles 35, 36 and support arm 30 are further mounted on a probe card 80 from which the needles 35 and 36 extend.

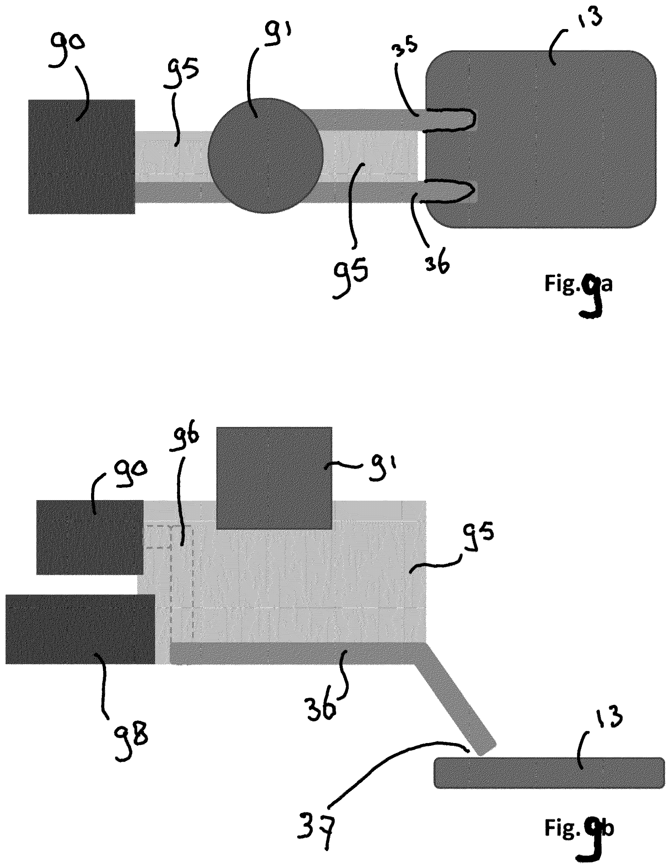

Figures 9a and 9b respectively illustrate a top view and side view of another sensing probe device design. The design of figures 9a and 9b includes a cryogenic arm 98 which enable to cool down the sensing probe device to cryogenic temperatures (note that `cryogenic temperatures' are universally defined as being temperatures below 120K (-153 degrees Celsius)). As may be appreciated, the sensing probe device may likewise be cooled down or heated to different temperatures, however for measuring the parameters of a quantum device 11, measuring is often performed at cryogenic temperatures. The design of figure 9a applies a different connector 90 and 91 for respectively the first and second needle 35 and 36. Furthermore, the support 95 leaves room for the mounting of the cryogenic probe arm 98 which enables cooling of the sensing probe device. Signal leads 96 are schematically illustrated on the support 95.

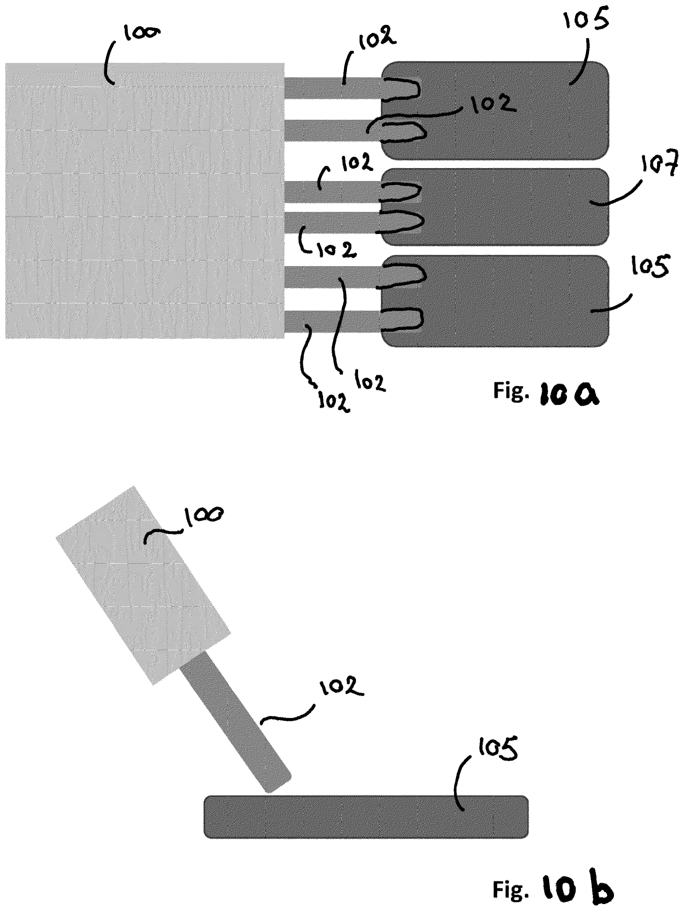

Figures 10a and 10b illustrate another sensing probe device design in accordance with some embodiments of the present invention. Here, a support 100 support plurality of probing needles 102 extending therefrom. As can be seen in side view 10b, each probe 102, after engaging the probe pad 105, 107, contacts the contact surface of the probe pad 105, 107. In the illustrated embodiments the probe pads 105 are grounded probe pads providing an electrical ground for measuring. Probe pad 107 is connected the device, and can be used for measuring the parameter of the device 11. Preferably, prior to measurement in step 63, using a sensing probe device design illustrated in figures 10a and 10b, first a measurement is performed between each of the signal bearing needles 102 in contact met probe pad 107 and each of the grounded needles 102 in contact with the grounded probe pads 105.

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

The present invention has been described in terms of some specific embodiments thereof. It will be appreciated that the embodiments shown in the drawings and described herein are intended for illustrated purposes only and are not by any manner or means intended to be restrictive on the invention. It is believed that the operation and construction of the present invention will be apparent from the foregoing description and drawings appended thereto. It will be clear to the skilled person that the invention is not limited to any embodiment herein described and that modifications are possible which should be considered within the scope of the appended claims. Also kinematic inversions are considered inherently disclosed and to be within the scope of the invention. Moreover, any of the components and elements of the various embodiments disclosed may be combined or may be incorporated in other embodiments where considered necessary, desired or preferred, without departing from the scope of the invention as defined in the claims.

In the claims, any reference signs shall not be construed as limiting the claim. The term 'comprising' and 'including' when used in this description or the appended claims should not be construed in an exclusive or exhaustive sense but rather in an inclusive sense. Thus the expression 'comprising' as used herein does not exclude the presence of other elements or steps in addition to those listed in any claim. Expressions such as "consisting of', when used in this description or the appended claims, should be construed not as an exhaustive enumeration but rather in an inclusive sense of "at least consisting of". Furthermore, the words 'a' and 'an' shall not be construed as limited to 'only one', but instead are used to mean 'at least one', and do not exclude a plurality. Features that are not specifically or explicitly described or claimed may be additionally included in the structure of the invention within its scope. Any of the claimed or disclosed devices or portions thereof may be combined together or separated into further portions unless specifically stated otherwise, without departing from the claimed invention. Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. Additions, deletions, and modifications within the purview of the skilled person may generally be made without departing from the spirit and scope of the invention, as is determined by the claims. The invention may be practiced otherwise then as specifically described herein, and is only limited by the appended claims.

## Claims

1. Method of measuring a parameter of a quantum chip using at least one sensing probe device, the quantum chip comprising a quantum device and at least one probe pad in conductive contact with the quantum device for enabling said measuring, wherein the method comprises the steps of:
a. engaging contact between the at least one sensing probe device and a contact surface of the probe pad; and
c. measuring, using the sensing probe device in contact with the probe pad, the parameter of the quantum device;
wherein the sensing probe device comprises at least two probe tips, the at least two probe tips being electrically separated from each other, and wherein prior to step c. and after step a., the method comprises a step b. of conductance testing and conditional surface conditioning of the contact surface, the step b. comprising at least the sub-steps of:
b1. measuring a contact impedance between the at least two electrically separated probe tips, the at least two electrically separated probe tips being in contact with the contact surface;
b2. determining, based on the measured contact impedance, whether the contact impedance is sufficient for enabling the measuring of the parameter of the quantum device in step c.;
b3. if in step b2. it is determined that the contact impedance is insufficient, perform a step of surface conditioning on the contact surface of the probe pad for lowering the contact impedance.

2. Method according to claim 1, wherein after the step of surface conditioning in step b3. the method further comprises repeating steps b1., b2., and b3. until in step b2. it is determined that the contact impedance is sufficient for enabling the measuring of the parameter of the quantum device in step c.

3. Method according to claim 1 or 2, wherein step b. further comprises a sub-step of:
b4. if in step b2. it is determined that the contact impedance is insufficient, continuing the method with step c. of measuring the parameter of the quantum device.

4. Method according to any one or more of the preceding claims, wherein the sensing probe device comprises at least two probes, wherein each probe of the at least two probes comprises a probe tip, such as to provide the at least two electrically separated probe tips; and
wherein in step a contact is engaged between the contact surface of the probe pad and each probe tip of the at least two probe tips; and
wherein in step c. the measuring is performed using at least one of the at least two probe tips in contact with the probe pad.

5. Method according to any one or more of claims 1-3, wherein the sensing probe device comprises a probe, wherein the probe includes the at least two electrically separated probe tips;
wherein in step a contact is engaged simultaneously between the contact surface of the probe pad and each of the at least two probe tips; and
wherein in step c. the measuring is performed using at least one of the at least two probe tips in contact with the probe pad.

6. Method according to any one or more of the preceding claims, wherein in step b3. the step of surface conditioning comprises at least one of:
moving the probe tips relative to the probe pad while the probe tips are in contact with the contact surface, for performing a mechanical scratching operation; or
disengage and re-engage contact between the at least two probe tips and the contact surface; or
applying a voltage between the at least two probe tips for electrically breaking down an insulating contamination between at least one of the probe tips and the probe pad; or
applying a current via the at least two probe tips for electrically breaking down an insulating contamination between at least one of the probe tips and the probe pad.

7. Method according to any one or more of the preceding claims, wherein in step b1. the measuring of a contact impedance comprises at least one of: contact resistance measurements, capacitive measurements, inductance measurements, current measurements, voltage measurements.

8. Method according to any one or more of the preceding claims, wherein the quantum device comprises at least two probe pads and wherein the measuring is performed using at least two sensing probe devices, wherein step a. at least comprises the sub-steps of:
a1. engaging contact between a first sensing probe device of the at least two sensing probe devices and a contact surface of a first probe pad of the at least two probe pads; and
a2. engaging contact between a second sensing probe device of the at least two sensing probe devices and a contact surface of a second probe pad of the at least two probe pads;
wherein step b. is performed for each one of the first and second sensing probe device in contact with respectively the first and second probe pad.

9. Method according to any one or more of the preceding claims, wherein at least one of:
the quantum chip comprises a plurality of quantum devices, each quantum device being in conductive contact with one or more probe pads, wherein the method is performed for two or more quantum devices of the plurality of quantum devices; or
the quantum chip is provided on a substrate, wherein the substrate comprises a plurality of quantum chips, and wherein the method is performed for each quantum chip on the substrate.

10. Sensing probe device for use in a method according to any one or more of claim 1-9, for measuring a parameter of a quantum chip, the quantum chip comprising a quantum device and at least one probe pad in conductive contact with the quantum device, wherein the sensing probe device is mountable to an actuator for enabling the sensing probe device to engage contact with a contact surface of the at least one probe pad, wherein the sensing probe device is configured for enabling measuring, using the sensing probe device in contact with the probe pad, the parameter of the quantum device;
wherein the sensing probe device, for contacting the contact surface, comprises at least two probe tips which are electrically separated from each other,
wherein each of the at least two probe tips is electrically connected separately such to convey an electrical signal thereto, for enabling measuring a contact impedance between the at least two electrically separated probe tips when said probe tips are in contact with the contact surface.

11. Sensing probe device according to claim 10, wherein each of the at least two probe tips is electrically connected to a signal connector via a signal lead, and wherein each of the signal leads is electrically shielded from its environment.

12. Sensing probe device according to claim 11, wherein the electric shielding is provided by a driven shield, the driven shield being connected such as to be maintained, in use, at a same voltage as the respective signal lead.

13. Sensing probe device according to any one or more of claims 10-12, wherein the sensing probe device is a cryogenic probe device including cooling means for maintaining the probe and probe tips in use at a cryogenic temperature.

14. Sensing probe device according to any one or more of claims 10-13, comprising at least a first needle and a second needle, wherein the first needle and the second needle are supported on a carrier structure, such as a support arm, and wherein a first probe tip of the at least two probe tips is formed on the first needle and a second probe tip of the at least two probe tips is formed on the second needle, wherein the first needle and the second needle are electrically separated from each other for forming a first signal lead and a second signal lead respectively.

15. Probe station for measuring a parameter of a quantum chip, the quantum chip comprising a quantum device and at least one probe pad in conductive contact with the quantum device for enabling said measuring, wherein the probe station comprises one or more sensing probe devices according to any one or more of claims 10-14, wherein the probe station comprises or is configured for operatively connecting to a data acquisition system for processing measurements obtained by said measuring, and
wherein the probe station comprises a controller, a memory and one or more actuators operated by the controller and configured for operating the one or more sensing probe devices for performing a method according to any one or more of claims 1-9.

16. Computer program product comprising instructions which, when the program is executed by a probe station comprising a controller and memory, cause the probe station to carry out [the steps of] the method according to any one or more of claims 1-9.
